# EUROPEAN PATENT SPECIFICATION

(11) **EP 0 570 816 B1**
(45) Date of publication and mention of the grant of the patent: **30.07.1997**
(21) Application number: 93107668.1
(22) Date of filing: 11.05.1993
(51) Int. Cl.: G01J 5/06, H01L 31/024

(54) **Infrared detector**
Infrarotdetektor
Détecteur à infrarouge

(30) Priority: 19.05.1992 JP 152658/92
(43) Date of publication of application: 24.11.1993
(73) Proprietor: MITSUBISHI DENKI KABUSHIKI KAISHA, Tokyo (JP)
(72) Inventor: Iwasaki, Naoko, c/o Mitsubishi Denki K. K., Amagasaki-shi, Hyogo-ken (JP); Ohno, Katsuhiro, c/o Mitsubishi Denki K. K., Amagasaki-shi, Hyogo-ken (JP)
(74) Representative: Pfenning, Meinig & Partner

(56) References cited:
- EP-A- 0 419 371
- US-A- 5 111 050
- PATENT ABSTRACTS OF JAPAN vol. 14, no. 515 (E-1000)(4458) 13 November 1990 & JP - A - 02 214 158.
- PATENT ABSTRACTS OF JAPAN vol. 13, no. 26 (E-706)(3374) 20 January 1989 & JP - A - 63 228 675.

## Description

The present invention relates to an infrared detector according to the pre-characterizing part of claim 1.

Infrared detectors that utilize a semiconductor silicon Schottky Junction are difficult to operate at room temperature because of their low Junction barrier. Therefore, this type of infrared detector must be operated in a state where they are cooled to cryogenic temperatures (liquid nitrogen temperature of about 80 K) in order to remove temperature disturbance. For this reason, an infrared detecting device is mounted in a vessel called dewar, which has a special structure that is provided with a window for transmitting infrared radiation and capable of cooling the detecting device to cryogenic temperatures. In this state, the detecting device is driven to detect infrared radiation.

Fig. 2 is a sectional view showing the structure of a conventional infrared detector of the type described above. In the figure, reference numeral 1 denotes a dewar the inside of which is kept at a vacuum. The dewar 1 comprises an outer cylinder 1b having a window member 1a hermetically bonded thereto for transmitting incident infrared radiation 3, and an inner cylinder 1c that is united with the outer cylinder 1b so as to form a cooler insertion space 10, which will be described later. The inner cylinder 1c is made of a glass, ceramic or metallic material which exhibits a small thermal conductivity at cryogenic temperatures, for example, borosilicate glass, metallic titanium, etc. A container 4 for mounting a detecting device is attached to an inner cylinder end portion ld made of a Kovar. The container 4 comprises a bottom plate 4a of aluminum nitride (AlN) or silicon carbide (SiC) which is secured to a surface of the inner cylinder end portion 1d that is disposed inside the dewar 1, and a frame 4b of alumina (Al₂O₃) or mullite (Al₂O₃:SiO₂ = 1:1) which is attached to the periphery of the bottom plate 4a and which is provided with terminals 11 for taking out an electric signal from a semiconductor infrared detecting device 6. Reference numerals 6a and 6b respectively denote first and second major surfaces of a semiconductor substrate that constitutes the detecting device 6. The first major surface 6a is formed with an infrared receiving part and a readout mechanism for reading out a signal from the infrared receiving part. The infrared detecting device 6 is disposed such that the first major surface 6a faces the bottom plate 4a of the container 4, and it is secured to the frame 4b of the container 4, thereby being mounted in the dewar 1. A cold shield 7 is attached to the frame 4b so as to cover the infrared detecting device 6, thereby forming a wall for shielding stray light of incident infrared radiation. A metallic conductor 14 electrically connects together a signal output part of the infrared detecting device 6 and an internal metallic lead formed inside the container 4. A dewar internal conductor 8 is connected to a terminal 11 of the frame 4b through a metallic conductor 12, disposed along the side wall of the inner cylinder 1c and led out of the dewar 1 through a metallic conductor 13 via an external terminal 9 extending through the outer cylinder 1b and hermetically sealed with glass. Reference numeral 10 denotes a cooler insertion space formed by the inner cylinder 1c.

The operation of the conventional infrared detector will be explained below.

Infrared radiation 3 that enters the dewar 1 through the window member 1a forms an image on the reverse surface of the semiconductor detecting device 6 (i.e., the first major surface 6a of the substrate), producing carrier charge in accordance with the intensity of the incident infrared radiation. The charge is read by a charge transfer part integrated with the detecting device 6 as one unit, and the read information is sent to an external signal processing circuit through the metallic conductors 14, the container internal metallic leads, the terminals 11, the metallic conductors 12, the dewar internal conductors 8, the metallic conductors 13 and the external terminals 9 and displayed as image information. During the detector operation, the detecting device 6 is cooled to a level of 80 K through the dewar inner cylinder end portion 1d by a cooling means, comprising a cooler, e.g., a Joule-Thomson or closed cycle cooler, which is inserted in the cooler insertion space 10 formed in the dewar 1.

In the conventional infrared detector with the above-described arrangement, the detecting device 6 is cooled through a heat transfer path formed from the dewar inner cylinder end portion 1d, the container bottom plate 4a and the frame 4b, and only the peripheral portion of the detecting device 6 is secured to the frame 4b. Accordingly, the thermal resistance is disadvantageously high, and it is difficult to realize efficient cooling.

In addition, since each member that constitutes the infrared detector is used over a wide temperature range of from room temperatures to cryogenic temperatures, a material for each member needs to be selected by taking into consideration characteristics, durability and thermal expansion under such temperature conditions. If the selection of a material is not properly made, the detecting device 6 or the container bottom plate 4a may be damaged by thermal stresses generated owing to a mismatch in thermal expansion during cooling.

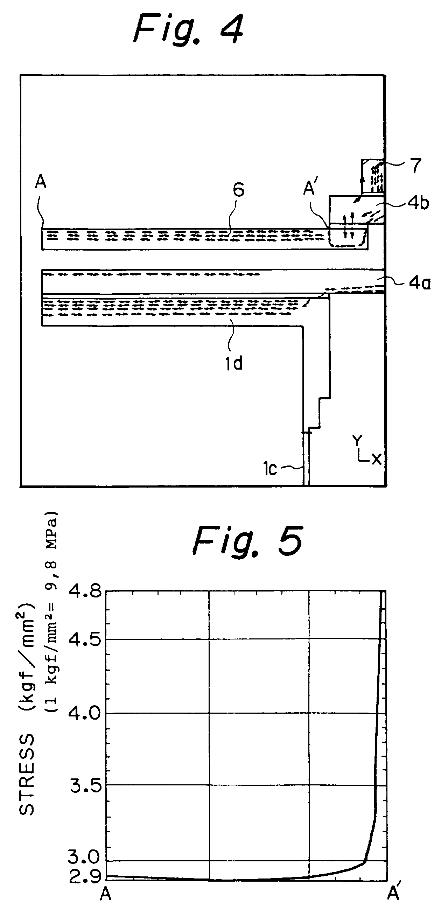

Fig. 4 is a fragmentary sectional view showing the right-hand half of the peripheral portion of the detecting device 6 in the conventional detector structure, shown in Fig. 2. In the figure, the same reference numerals as those in Fig. 2 denote the same elements or portions. The point A shows the central portion of the infrared detecting device 6. The point A' shows an area where the infrared detecting device 6 is bonded to the frame 4b. The arrows represent stresses generated in the device 6. Fig. 5 is a graph showing contraction stresses generated on the device surface (A-A' in Fig. 4) in a direction X (horizontal direction as viewed in Fig. 4) when the composite structure, which comprises the inner cylinder 1c of the dewar 1, the inner cylinder end portion 1d, the bottom plate 4a of the container 4, the container frame 4b, the infrared detecting device 6 and the cold shield 7, is cooled from a room temperature (300 K) to a cryogenic temperature (77 K). As will be clear from Fig. 5, stresses that are generated on the device surface in the conventional structure are in the range of 28,4 to 47,0 MPa (2.9 to 4.8 kgf/mm²). Here, a positive value for stress represents tensile stress, whereas a negative value represents compressive stress. In general, a brittle material such as aluminum nitride or silicon carbide may be cracked by tensile stress. Therefore, in the conventional device structure, the container bottom plate 4a or the detecting device 6 may be damaged by thermal stresses generated during cooling.

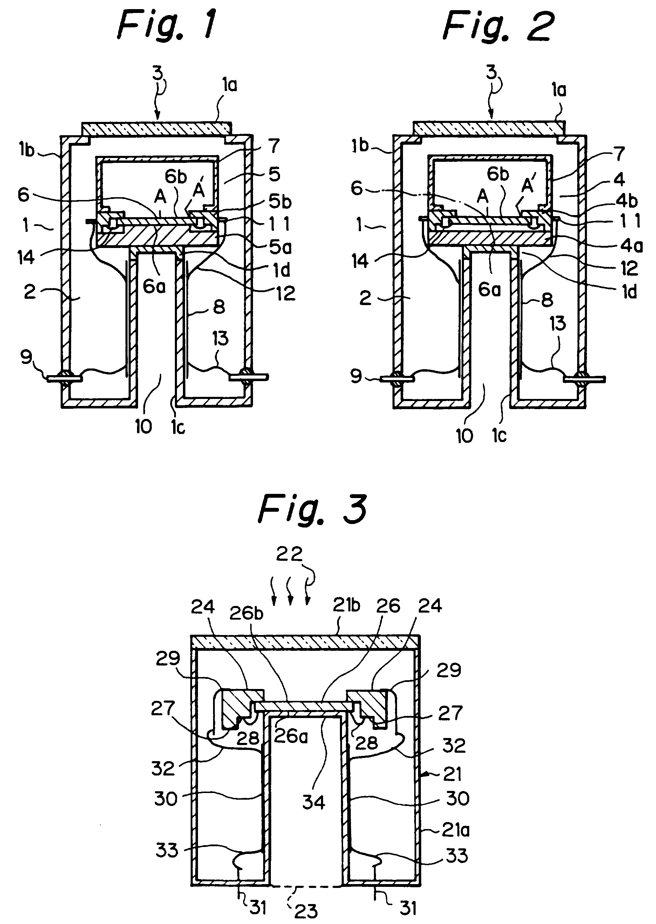

Fig. 3 is a sectional view showing the structure of another conventional infrared detector disclosed in Japanese Patent Application Public Disclosure No. 2-214158 (1990). In the figure, a dewar 21 the inside of which is kept at a vacuum comprises a tubular portion 21a and a window portion 21b that is formed at the upper end of the tubular portion 21a for allowing infrared radiation to enter the dewar 21. A cooling means 23 is inserted into a recess formed in the tubular portion 21a. An infrared detecting device 26 is secured at its peripheral portion to a support 24. Reference numerals 26a and 26b respectively denote first and second major surfaces of the infrared detecting device 26. The first major surface 26a is formed with a readout mechanism for reading out a signal from an infrared receiving part. The first major surface 26a is directly placed on and secured to the inner surface of the upper end of the recess formed in the tubular portion 21a of the dewar 21. Internal metallic leads 27 are electrically connected to the infrared detecting device 26 through metallic conductors 28. External metallic leads 29 are provided to lead out an output from the infrared detecting device 26. Metallic leads 30 are secured to the inner surfaces of the tubular portion 21a. Electrodes 31 are used to take out the output signal from the detecting device 26 in the dewar 21 to the outside of the dewar 21. Metallic conductors 32 and 33 provide electrical connection between the metallic leads 29 and 30 and between the leads 30 and the electrodes 31.

In this infrared detector, since the first major surface 26a of the infrared detecting device 26 is directly placed on and secured to the upper end of the recess formed in the tubular portion 21a of the dewar 21, the thermal resistance between the cooling means 23 and the infrared detecting device 26 can be reduced, and the cooling efficiency can be improved by a large margin. Accordingly, the problems attendant on the structure of the first-described prior art are solved. In this structure, however, the infrared detecting device 26 is not provided in a container but directly placed on and secured to the upper end of the recess of the dewar 21. Accordingly, light that enters the dewar 21 from the outside and that is reflected from the inner wall of the dewar 21 may enter the device 26 through a surface thereof (first major surface 26a) to form a noise component, causing the device characteristics to be deteriorated. In addition, the device 26 may be damaged when mounted in the dewar 21, and if such occurs, the reliability of the device 26 lowers.

Thus, the first conventional infrared detector, shown in Fig. 2, suffers from the problem that the thermal resistance increases when the detecting device is cooled, and it is therefore difficult to realize efficient cooling. In addition, the detecting device or the container bottom plate may be damaged by thermal stresses generated owing to a mismatch in thermal expansion during cooling.

In the second conventional infrared detector, shown in Fig. 3, intrusion of ambient light cannot be prevented, so that the device characteristics may be deteriorated. The second prior art further suffers from the problem that the device may be damaged when mounted in the dewar.

US-A-5 111 050 already discloses a silicon infrared detector including a dewar having an outer cylinder with a window for transmitting incident infrared radiation and an inner cylinder united with the outer cylinder so as to form a space for inserting a cooling means. An infrared detecting device is accommodated in the dewar and driven to a cryogenic temperature by the cooling means from the outside of the dewar. A container for accommodating the infrared detecting device includes a bottom plate to which the detecting device is secured, and the bottom plate is secured to an end position of the inner cylinder.

In view of the above-described problems of the prior art, it is an object of the present invention to provide an infrared detector which is designed so that the detecting device can be cooled efficiently without increasing the thermal stresses generated in the device body owing to cooling during the operation of the detector, and it is also possible to prevent intrusion of ambient light and enable the device to be readly disposed in the dewar.

Accordingly to the present invention this object is solved by the features of claim 1. Prefered embodiments of the infrared detector according to the invention are defined in the dependent claims.

The above object, features and advantages of the present invention will become more apparent from the following description of the preferred embodiments thereof, taken in conjunction with the accompanying drawings, in which like reference numerals denote like elements, and of which:
Fig. 1 is a sectional view of an infrared detector according to one embodiment of the present invention;
Fig. 2 is a sectional view of a conventional infrared detector;
Fig. 3 is a sectional view of another conventional infrared detector;
Fig. 4 is a fragmentary enlarged view of a peripheral portion of a detecting device of a conventional infrared detector;
Fig. 5 is a graph showing stresses generated on the device surface of a conventional infrared detector;
Fig. 6 is a graph showing stresses generated on the device surface of an infrared detector according to one embodiment of the present invention; and
Fig. 7 is a graph showing stresses generated on the device surface of an infrared detector according to another embodiment of the present invention.

One embodiment of the present invention will be described below with reference to the accompanying drawings. Fig. 1 is a sectional view showing the structure of an infrared detector according to one embodiment of the present invention. In the figure, the same reference numerals as those in Fig. 2 denote the same elements or portions. However, reference numeral 5 denotes a container which comprises a bottom plate 5a made of an Invar (36% Ni - 64% Fe) and having a projection formed in the center thereof, and a frame 5b of alumina which is bonded to the peripheral portion of the bottom plate 5a. The feature of this embodiment resides in that the inner cylinder end portion 1d of the dewar 1 is made of a Kovar (29% Ni - 17% Co - 54% Fe), and the infrared detecting device 6 is directly placed on and secured to the projection formed in the center of the container bottom plate 5a made of the Invar.

It was decided to employ the above-described constituent materials on the basis of the results of a simulation carried out using a computer. That is, contraction stresses generated when the composite structure, which comprised the inner cylinder 1c of the dewar 1, the inner cylinder end portion 1d, the bottom plate 5a of the container 5, the container frame 5b, the infrared detecting device 6 and the cold shield 7, was cooled from a room temperature (300 K) to a cryogenic temperature (77 K) were measured by a computer numerical analysis based on the finite element method with each kind of constituent material used as a parameter, and utilized particularly for evaluation of stresses in the infrared detecting device 6.

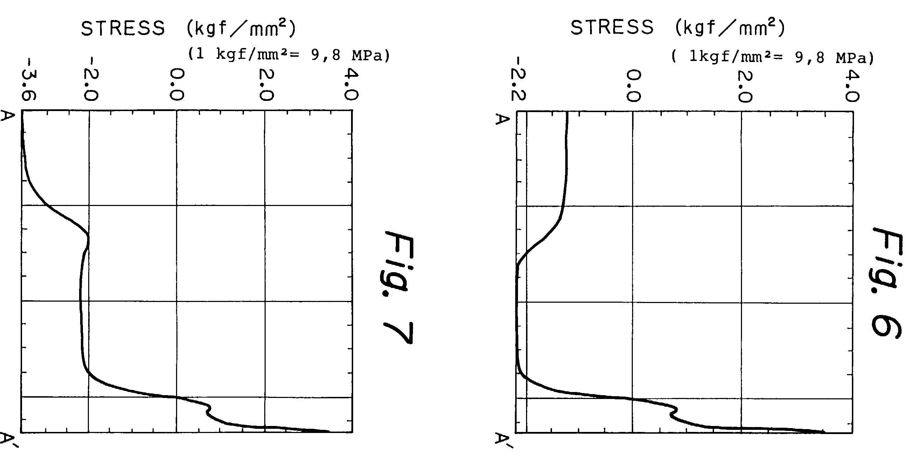

Fig. 6 is a graph showing a distribution of stresses generated on the device surface of the infrared detector in this embodiment. As will be clear from the graph, the results of the analysis reveal that stresses generated on the surface of the device in this embodiment are in the range of -21,6 to 39,2 MPa (-2.2 to 4.0 kgf/mm²), and that the maximum stress in the detector of this embodiment is 39,2 MPa (4.0 kgf/mm²), whereas the maximum stress in the conventional infrared detector, shown in Fig. 2, is 47,0 MPa (4.8 kgf/mm²). Thus, in the detector of this embodiment, stresses generated in the device body are held down to a lower level than in the case of the conventional detector.

Further, in the conventional detector structure, shown in Fig. 2, cooling of the infrared detecting device is effected through container bottom plate and the frame. In the infrared detector of this embodiment, however, the detecting device 6 is mounted directly on the projection formed in the center of the container bottom plate 5a, so that efficient cooling can be performed through a heat transfer path which is formed from the dewar inner cylinder end portion 1d and the container bottom plate 5a.

Further, since in this embodiment the container 5 is comprised of the bottom plate 5a and the frame 5b, which is bonded to the peripheral portion of the bottom plate 5a, and the infrared detecting device 6 is placed on and secured to the projection of the bottom plate 5a, there is no likelihood that light that enters the dewar 1 and that is reflected from the dewar inner wall will enter the device 6 through the surface 6a thereof. Thus, it is possible to prevent intrusion of ambient light and hence possible to reduce noise and improve the device characteristics.

In addition, since the device 6 is disposed in the container 5, it is easy to handle the device 6 when it is mounted in the dewar 1. Accordingly, reliability of the device 6 is improved.

Further, since the container bottom plate 5a is made of an Invar, machining of the bottom plate 5a is facilitated.

Next, the structure of an infrared detector according to another embodiment of the present invention will be described with reference to Fig. 1. In the figure, the same reference numerals as those in Fig. 2 denote the same elements or portions. However, reference numeral 5 denotes a container which comprises a bottom plate 5a made of an Invar and having a projection formed in the center thereof, and a frame 5b of alumina which is bonded to the peripheral portion of the bottom plate 5a. In this embodiment, the inner cylinder end portion 1d of the dewar 1 is made of an Invar.

It was decided to employ the above-described constituent materials on the basis of the results of a simulation carried out using a computer in the same way as in the first embodiment. Fig. 7 is a graph showing a distribution of stresses generated on the device surface of the infrared detector in this embodiment. As will be clear from the graph, the results of the analysis reveal that stresses generated on the surface of the device in this embodiment are in the range of -35,3 to 39,2 MPa (-3.6 to 4.0 kgf/mm²), and that the maximum stress in the detector of this embodiment is 39,2 MPa (4.0 kgf/mm²), whereas the maximum stress in the conventional infrared detector, shown in Fig. 2, is 47,0 MPa (4.8 kgf/mm²). Thus, in the detector of this embodiment, stresses generated in the device body are held down to a lower level than in the case of the conventional detector.

Further, the infrared detector of this embodiment also provides advantageous effects similar to those in the first embodiment. That is, the cooling efficiency is high, and intrusion of ambient light can be prevented. Further, it is easy to mount the detecting device in the dewar, and it is also easy to effect machining during formation of the container bottom plate.

Thus, in the infrared detector of the present invention, the infrared detecting device is mounted directly on the projection formed in the center of the container bottom plate. Therefore, the device can be efficiently cooled during the operation. Further, since the bottom plate is made of an Invar and the inner cylinder end portion is made of an Invar or a Kovar, it is possible to minimize stresses generated in the periphery of the bonded portion of the device when it is cooled to cryogenic temperatures. In addition, since the device is provided in the container and this container is disposed in the dewar, intrusion of ambient light can be prevent, and it is easy to handle the device when it is mounted in the dewar. Further, since the container bottom plate is made of an Invar, machining of the bottom plate is facilitated.

Although the present invention has been described through specific terms, it should be noted here that the described embodiments are not necessarily exclusive and that various changes and modifications may be imparted thereto without departing from the scope of the invention which is limited solely by the appended claims.

## Claims

1. An infrared detector including:
a dewar (1) having an outer cylinder (1b) with a window (1a) for transmitting incident infrared radiation, and an inner cylinder (1c) united with said outer cylinder (1b) so as to form a space (10) for inserting cooling means, and a silicon infrared detecting device (6) accommodated in a container (5) inside said dewar (1) and driven while being cooled to a cryogenic temperature by said cooling means from the outside of said dewar (1)
**characterized** in that
an end portion (1d) of said inner cylinder (1c) which is disposed inside said dewar (1) is made of a Kovar or an Invar, said container (5) including a bottom plate (5a) made of an Invar and having a projection projecting inwardly of said container (5) from an inner surface thereof, so that said silicon infrared detecting device (6) is secured to said projection of said bottom plate (5a), said bottom plate (5a) being secured to said end portion (1d) of said inner cylinder (1c) of said dewar (1), thereby disposing said container (5) in said dewar (1).

2. An infrared detector according to Claim 1, characterized in that said container (5) for said infrared detecting device (6) comprises said bottom plate (5a), a frame (5b) secured to said bottom plate (5a) to constitute a part of said container (5), and a cold shield (7) secured to said frame (5b) to constitute a part of said container (5), and an upper surface (6b) of said infrared detecting device (6) is secured to said frame (5b).

3. An infrared detector according to Claim 2, characterized in that said infrared detecting device (6) comprises a semiconductor substrate having a first major surface (6a) and a second major surface (6b), said first major surface (6a) being connected to said frame (5b) through metallic conductors (14), said frame (5b) being provided with terminals (11), which are connected through metallic conductors (12) to dewar internal conductors (8) attached to a side surface of said inner cylinder (1c) inside said dewar (1), and said dewar internal conductors (8) being connected through metallic conductors (13) to external terminals (9) provided on said outer cylinder (1b) of said dewar (1).

4. An infrared detector according to Claim 2, characterized in that said infrared detecting device (6) comprises a semiconductor substrate having a first major surface (6a) and a second major surface (6b), said first major (6a) being secured to said projection of said bottom plate (5a), and said second major surface (6b) being bonded at a peripheral edge thereof to said frame (5b).

5. An infrared detector according to Claim 1, characterized in that said Invar contains 36 % Ni and 64 % Fe.

6. An infrared detector according to Claim 1, characterized in that said Kovar contains 29 % Ni, 17 % Co and 54 % Fe.

## Patentansprüche

1. Infrarotdetektor, enthaltend:
ein Dewar-Gefäß (1) aufweisend einen äußeren Zylinder (1b) mit einem Fenster (1a) zum Durchlassen auftreffender Infrarotstrahlung und einen so mit dem äußeren Zylinder (1b) vereinigten inneren Zylinder (1c), daß ein Raum (10) zum Einführen von Kühlmitteln gebildet wird, und eine Silizium-Infraroterfassungsvorrichtung (6), die in einem Behälter (5) innerhalb des Dewar-Gefäßes (1) aufgenommen ist und betrieben wird, während sie durch das Kühlmittel von der Außenseite des Dewar-Gefäßes (1) auf eine Tiefsttemperatur abgekühlt wird,
**dadurch gekennzeichnet**, daß
ein Endbereich (1d) des inneren Zylinders (1c), welcher sich innerhalb des Dewar-Gefäßes (1) befindet, aus Kovar oder Invar gebildet ist, der Behälter (5) enthaltend eine Bodenplatte (5a) aus Invar besteht und einen Vorsprung aufweist, der von dem Behälter (5) von einer inneren Oberfläche von diesem nach innen so vorsteht, daß die Silizium-Infraroterfassungsvorrichtung (6) an dem Vorsprung der Bodenplatte (5a) befestigt ist, wobei die Bodenplatte (5a) an dem Endbereich (1d) des inneren Zylinders (1c) des Dewar-Gefäßes (1) befestigt ist, wodurch der Behälter (5) in dem Dewar-Gefäß (1) angeordnet wird.

2. Infrarotdetektor nach Anspruch 1, dadurch gekennzeichnet, daß der Behälter (5) für die Infraroterfassungsvorrichtung (6) die Bodenplatte (5a), einen an der Bodenplatte (5a) befestigten Rahmen (5b), um einen Teil des Behälters (5) zu bilden, und einen an dem Rahmen (5b) befestigten Kälteschild, um einen Teil des Behälters (5) zu bilden, aufweist, und daß eine obere Oberfläche (6b) der Infraroterfassungsvorrichtung (6) an dem Rahmen (5b) befestigt ist.

3. Infrarotdetektor nach Anspruch 2, dadurch gekennzeichnet, daß die Infraroterfassungsvorrichtung (6) ein Halbleitersubstrat mit einer ersten Hauptfläche (6a) und einer zweiten Hauptfläche (6b) aufweist, wobei die erste Hauptfläche (6a) durch metallische Leiter (14) mit dem Rahmen (5b) verbunden ist, der Rahmen (5b) mit Anschlüssen (11) versehen ist, die durch metallische Leiter (12) mit internen Leitern (8) des Dewar-Gefäßes, die an einer Seitenoberfläche des inneren Zylinders (1c) innerhalb des Dewar-Gefäßes befestigt sind, verbunden sind, und die internen Leiter (8) des Dewar-Gefäßes durch metallische Leiter (13) mit externen Anschlüssen (9), die auf dem äußeren Zylinder (1b) des Dewar-Gefäßes (1) vorgesehen sind, verbunden sind.

4. Infrarotdetektor nach Anspruch 2, dadurch gekennzeichnet, daß die Infraroterfassungsvorrichtung (6) ein Halbleitersubstrat mit einer ersten Hauptfläche (6a) und einer zweiten Hauptfläche (6b) aufweist, wobei die erste Hauptfläche (6a) an dem Vorsprung der Bodenplatte (5a) befestigt ist und die zweite Hauptfläche (6b) an einer Umfangskante von dieser mit dem Rahmen (5b) verbunden ist.

5. Infrarotdetektor nach Anspruch 1, dadurch gekennzeichnet, daß das Invar 36 % Ni und 64 % Fe enthält.

6. Infrarotdetektor nach Anspruch 1, dadurch gekennzeichnet, daß das Kovar 29 % Ni, 17 % Co und 54 % Fe enthält.

## Revendications

1. Détecteur à infrarouge comprenant :
un Dewar (1) possédant un cylindre extérieur (1b) pourvu d'une fenêtre (1a) pour transmettre un rayonnement infrarouge incident, et un cylindre intérieur (lc) réuni audit cylindre extérieur (1b) de manière à former un espace (10) pour insérer des moyens de refroidissement, et un dispositif de détection à infrarouge à silicone (6) logé dans un récipient (5) situé à l'intérieur dudit Dewar (1) et actionné, tout en étant refroidi à une température cryogénique par lesdits moyens de refroidissement à partir de l'extérieur dudit vase de Dewar (1),
caractérisé en ce qu'
une partie d'extrémité (1d) dudit cylindre intérieur (1c), qui est disposée à l'intérieur dudit vase de Dewar (1) est formée de Kovar ou d'Invar, ledit récipient (5) comprenant une plaque de fond (5a) formée d'Invar et possédant une partie saillante qui pénètre à l'intérieur dudit récipient (5) à partir d'une surface intérieure de ce dernier, de sorte que ledit dispositif de détection à infrarouge à silicone (6) est fixé à ladite partie saillante de ladite plaque de fond (5a), ladite plaque de fond (5a) étant fixée à ladite partie d'extrémité (1d) dudit cylindre intérieur (1c) dudit Dewar (1), ce qui permet de disposer ledit récipient (5) dans ledit Dewar (1).

2. Détecteur à infrarouge selon la revendication 1, caractérisé en ce que ledit récipient (5) pour ledit dispositif de détection à infrarouge (6) comprend ladite plaque de fond (5a), un cadre (5b) fixé à ladite plaque de fond (5a) pour constituer une partie dudit récipient (5), et un écran (7) de protection vis-à-vis du froid fixé audit cadre (5b) pour former une partie dudit récipient (5), et une surface supérieure (6b) du dispositif de détection à infrarouge (6) est fixée audit cadre (5b).

3. Détecteur à infrarouge selon la revendication 2, caractérisé en ce que ledit dispositif de détection à infrarouge (6) comprend un substrat semiconducteur possédant une première surface principale (6a) et une seconde surface principale (6b), ladite première surface principale (6a) étant connectée audit cadre (5b) au moyen de conducteurs métalliques (14), ledit cadre (5b) étant pourvu de bornes (11), qui sont connectés par des conducteurs métalliques (12) aux conducteurs internes (8) du Dewar fixés à une surface latérale dudit cylindre intérieur (1c) à l'intérieur dudit Dewar (1), et lesdits conducteurs internes (8) du Dewar étant connectés par des conducteurs métalliques (13) à des bornes extérieures (9) prévues sur ledit cylindre extérieur (1b) dudit Dewar (1).

4. Détecteur à infrarouge selon la revendication 2, caractérisé en ce que ledit dispositif de détection à infrarouge (6) comprend un substrat semiconducteur comprenant une première surface principale (6a) et une seconde surface principale (6b), ladite première surface principale (6c) étant fixée à ladite partie saillante de ladite plaque de fond (6c), et ladite seconde surface principale (6b) étant liée, par un bord périphérique, audit cadre (5b).

5. Détecteur à infrarouge selon la revendication 1, caractérisé en ce que ledit Invar contient 36 % de Ni et 64 % de Fe.

6. Détecteur à infrarouge selon la revendication 1, caractérisé en ce que ledit Kovar contient 29 % de Ni, 17 % de Co et 54 % de Fe.
